# EUROPÄISCHE PATENTSCHRIFT

(11) **EP 1 203 404 B1**
(45) Veröffentlichungstag und Bekanntmachung des Hinweises auf die Patenterteilung: **08.05.2013**
(21) Anmeldenummer: 00956166.3
(22) Anmeldetag: 05.07.2000
(51) Int. Cl.: H01L 21/311

(54) **VERWENDUNG EINER ÄTZLÖSUNG, FLUSSSÄURE ENTHALTEND**
USE OF AN ETCHING SOLUTION, CONTAINING HYDROFLUORIC ACID
UTILISATION D'UNE SOLUTION DE GRAVURE CONTENANT DE L'ACIDE FLUORHYDRIQUE

(30) Priorität: 28.07.1999 DE 19935446
(43) Veröffentlichungstag der Anmeldung: 08.05.2002
(73) Patentinhaber: BASF SE, 67056 Ludwigshafen (DE)
(72) Erfinder: Wiegand, Claudia, D-64291 Darmstadt (DE); RHEIN, Rudolf, D-64646 Heppenheim (DE); TEMPEL, Eberhard, D-64342 Seeheim-Jugenheim (DE)
(86) Internationale Anmeldenummer: PCT/EP2000/006314
(87) Internationale Veröffentlichungsnummer: WO 2001/009935

(56) Entgegenhaltungen:
- CH-A- 664 978
- GB-A- 1 228 083
- DATABASE WPI Section Ch, Week 197931 Derwent Publications Ltd., London, GB; Class E16, AN 1979-57517B XP002152974 -& SU 628 161 A (PUSHECHNIKOV V P), 23. August 1978 (1978-08-23)
- PATENT ABSTRACTS OF JAPAN vol. 004, no. 059 (E-009), 2. Mai 1980 (1980-05-02) -& JP 55 030826 A (NEC KYUSHU LTD), 4. März 1980 (1980-03-04)
- PATENT ABSTRACTS OF JAPAN vol. 013, no. 371 (E-807), 17. August 1989 (1989-08-17) -& JP 01 125831 A (MINOLTA CAMERA CO LTD), 18. Mai 1989 (1989-05-18)
- "pages 615 and 617" In: Hawley: "Hawley's Condensed Chemical Dictionary", 1987, Van Nostrand Reinhold Company, New York ISBN: 0442280971

## Beschreibung

Diese Erfindung betrifft die Verwendung von Ätzlösungen im Herstellungsprozess von integrierten Schaltungen, die Flußsäure und organische Lösungsmittel enthalten. Besonders geeignet sind die erfindungsgemäßen Ätzlösungen zur selektiven Ätzung von dotierten Silikatschichten relative zu undotierten Silikatschichten.

In der Halbleiterindustrie werden zur Herstellung verschiedener Typen integrierter Schaltungen unterschiedliche dielektrische Schichten abgeschieden. Diese können z.B. abgeschiedene Borsilikatglas (BSG)-Schichten, Phosphorsilikatglas (PSG)-Schichten, Borphosphorsilikatglas (BPSG)-Schichten, Oxid-Schichten aus thermischem Oxid oder solche Oxid-Schichten, die aus Tetraethylorthosilikat (TEOS) abgeschieden werden, sein.

Üblicherweise werden an verschiedenen Stellen des Halbleiterprozesses dotierte Glasschichten auf undotierten Glasschichten aufgebracht. Hierbei handelt es sich meist um ein bordotiertes Glas (BSG) auf einem thermischen Oxid, ein phosphordotiertes Glas (PSG) auf einem thermischen Oxid oder ein bor-phosphordotiertes (BPSG) Glas auf einem thermischen Oxid. Ebenso können die zuvor genannten Schichten auch auf ein TEOS-Oxid aufgebracht werden.

Nachdem diese dotierten Schichten aufgebracht worden sind, müssen diese stellenweise durch Ätzung wieder abgetragen werden. In Abhängigkeit von der angestrebten Anwendung kann es erforderlich sein, BSG-, PSG- oder BPSG-Schichten selektiv zu thermischem oder TEOS-Oxid zu ätzen.

Da die dotierten Schichten eine Oberflächentopographie zeigen, bedingt durch die unterliegenden Strukturen, ist die abzutragende Schichtdicke nicht an allen Stellen des Wafers gleich groß. Um aber an allen zu ätzenden Stellen genügend Material abzutragen, muß die Ätzzeit so lang gewählt werden, bis auch die dicksten Schichten durchgeätzt sind. Da das Ätzmedium in dieser sogenannten Überätzzeit an den Stellen mit ursprünglich dünnerer Schicht an dotiertem Glas auf das unterliegende thermische bzw. TEOS-Oxid einwirkt, ist ein Ätzmedium erforderlich, welches die dotierten Oxide mit viel höherer Geschwindigkeit ätzt als die undotierten Oxide.

Zum Ätzen im Spinetcher-Betrieb werden hier bevorzugt Mischungen aus konzentrierter H₂SO₄ und 50 %-iger HF verwendet. Diese Mischungen weisen bereits eine Selektivität in Bezug auf verschiedene Schichten auf und führen im wesentlichen zu einer gleichmäßige Qualität der geätzen Schicht.

Eigene Versuche mit verschiedenen im Handel erhältlichen Atzmedien haben jedoch eine nicht ausreichende Selektivität beim Ätzen gezeigt. Es wurde dabei auch gefunden, daß mit anderen Mischungen zwar selektiv geätzt werden kann, die Gleichförmigkeit der Ätzung jedoch für die Prozesse nicht ausreichend ist.

Die CH664978 A5 offenbart eine Ätzlösung enthaltend eine stickstoffhaltige Verbindung und deren Verwendung zum Ätzen von oxidischen Materialien, u.a. Silikaten, die auch dotiert sein können.

Die SU628161 A (Abstract) offenbart die Verwendung einer Zusammensetzung enthaltend 36-42 Gew.-% Flußsäure, 55-65 Gew.-% Glycerin, 0,1 -10 Gew.-% Ethylenglycol und 0.1-10 Gew.-% Ethanolamin zum Ätzen von kristallinem Glas.

Die JP 55030826 A offenbart die Verwendung einer Ätzlösung enthaltend Flusssäure und Ethylenglycol zur selektiven Ätzung von Aluminiumoxidschichten, die auf Aluminium angeordnet sind.

Aufgabe der vorliegenden Erfindung ist daher, die Verwendung von Ätzmischungen für die Halbleiterindustrie zu Herstellung von integrierten Schaltungen, die bei hohen Ätzraten eine wesentlich verbesserte Selektivität aufweisen und einheitlich zu einer gleichförmigen Ätzung führen.

Die Lösung der Aufgabe erfolgt durch die Merkmale des Anspruchs 1.

In den erfindungsgemäß benutzten Ätzlösungen wird Flußsäure (HF) in einer Menge von 5-20 Gew.-% eingesetzt.

Die Ätzlösungen enthalten nur organisches Lösungsmittel ausgewählt aus der Gruppe Ethylenglykol, Propylenglykol, Ethanol und Glycerin.

Gegenstand der Erfindung ist auch die Verwendung von Ätzlösungen, welche als organisches Lösungsmittel ein Gemisch, bestehend aus Ethylenglykol und Glycerin in einem Mischungsverhältnis von 1:10 bis 10:1, enthalten.

Als gute Ätzlösungen im Rahmen der Erfindung haben sich solche erwiesen, die als organisches Lösungsmittel Ethylenglykol und Glycerin in einem Mischungsverhältnis von 1 : 5 bis 5 : 1 enthalten.

Die Ätzlösungen enthalten Wasser in einer Menge von 1 bis 20 Gew.-%.

Im Rahmen der Erfindung wird die Aufgabe dieser Erfindung durch Verwendung von Ätzlösungen gelöst, die eine Mischung aus hochreinen Einzelkomponenten enthalten.

Gegenstand der Erfindung ist die Verwendung der hiermit beschriebenen Ätzlösungen zur selektiven Ätzung von dotierten Silikatschichte relativ zu undotierten Silikatschichten.

Durch die hier entwickelten Gemische lassen sich die Selektivitäten und die Gleichmäßigkeit der Ätzung in Abhängigkeit vom Abscheidungsprozeß der einzelnen Schichten wesentlich verbessern.

Vorteilhaft ist, daß die mit den erfindungsgemäßen Lösungen erzielte Ätzrate für die Ätzung von PSG-Schichten, BSG-Schichten und BPSG-Schichten um ein vielfaches größer ist (bis zu >300) als für TEOS-Schichten oder Schichten aus thermischem Oxid.

Diese Selektivitäten wurden beim Ätzen auf einem Spinetcher und während Tauchätzungen beobachtet.

Als organische Lösungsmittel werden Ethylenglykol, Propylenglykol, Ethanol, Glycerin oder deren Mischungen verwendet. Die unter Verwendung dieser Lösungsmittel erzielbaren Ätzraten sind abhängig vom verwendeten Lösungsmittel, bzw. vom Mischungsverhältnis der einzelnen organischen Lösungsmittel zueinander. Weiterhin wird die Ätzrate stark von der in der Lösung enthaltenen Menge Flußsäure und ganz besonders von der enthaltenen Menge Wasser beeinflußt.

Der Gehalt an Flußsäure liegt zwischen 5 - und 20 Gew.-% HF. Als Lösungsmittel eignet sich vor allem reines Ethylenglykol, reines Ethanol oder reines Glycerin. Bei den Lösungsmittelgemischen zeigten insbesondere die Mischungen von Glycerin und Ethylenglykol im Verhältnis 1 : 10 bis 10 : 1 ein sehr selektives Ätzverhalten.

Gerade im Tauchätzprozeß zeigt sich bei den der Erfindung zugrunde liegenden Ätzlösungen eine wesentlich gleichmäßigere Ätzung als bei Verwendung handelsüblicher Ätzlösungen.

Die folgende Tabelle gibt einige Beispiele für die erzielten Selektivitäten zwischen BSG-Glas und thermischem Oxid, erzielt im Tauchätzverfahren:

**Tabelle 1**

| Nr. | Organische Komponente | Selektivität (BSG zu therm. Oxid) |
|---|---|---|
| 1 | Ethylenglykol | 97 |
| 2 | Glycerin | 124 |
| 3 | Ethylenglykol : Glycerin = 1: 1 | 101 |
| 4 | Ethylenglykol : Glycerin = 1 : 2 | 69 |
| 5 | Ethylenglykol : Glycerin = 2: 1 | 76 |

Ein großer Vorteil gegenüber den bestehenden Mischungen ist die Gleichmäßigkeit der Oberfläche nach dem Ätzen. Diese verbesserte Uniformität wirkt sich deshalb positiv auf den Ätzprozeß aus, weil dadurch die Überätzzeiten wesentlich verkürzt werden können. Aufnahmen 1 bis 3 zeigen REM-Aufnahmen einer durch Tauchätzen mit Spinetch F als Vergleichslösung geätzten BSG-Schicht. Ganz besonders deutlich ist auf der Aufnahme 3 ein während des Ätzens gebildetes, unerwünschtes Loch in der Oberfläche zu erkennen.

Entsprechende Löcher werden bei der erfindungsgemäßen Verwendung der Ätzlösungen nicht gefunden.

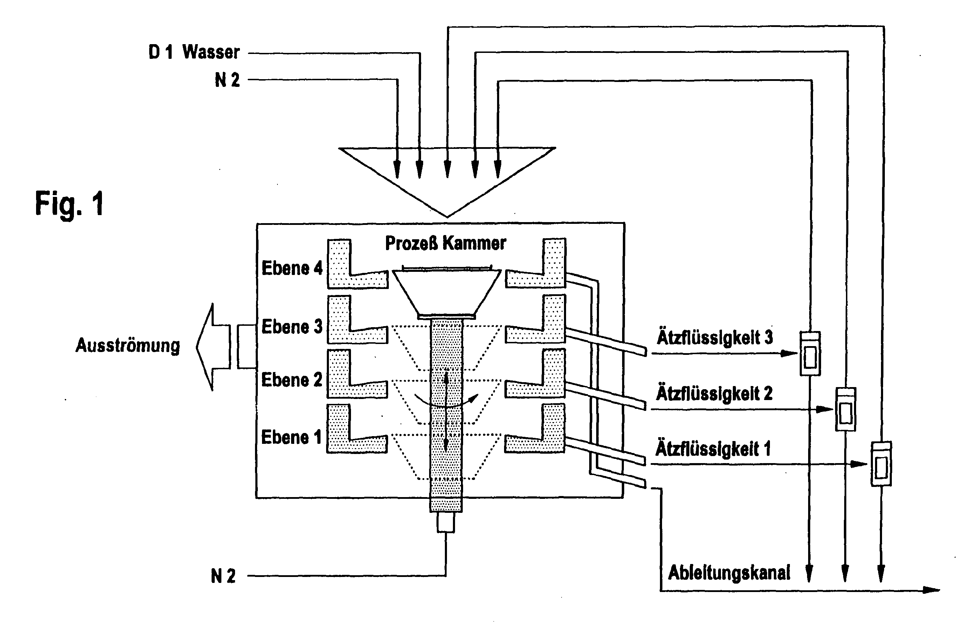

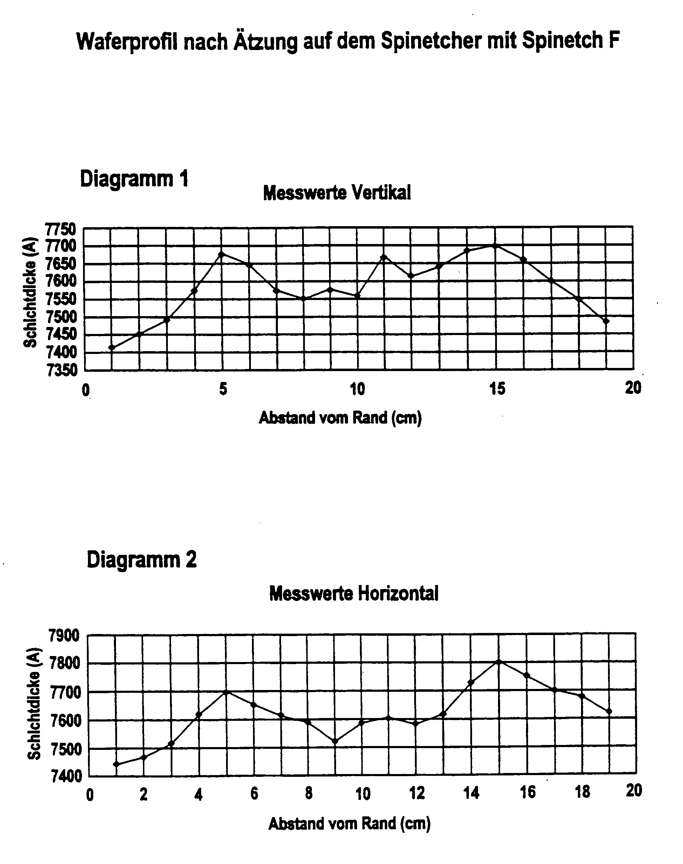

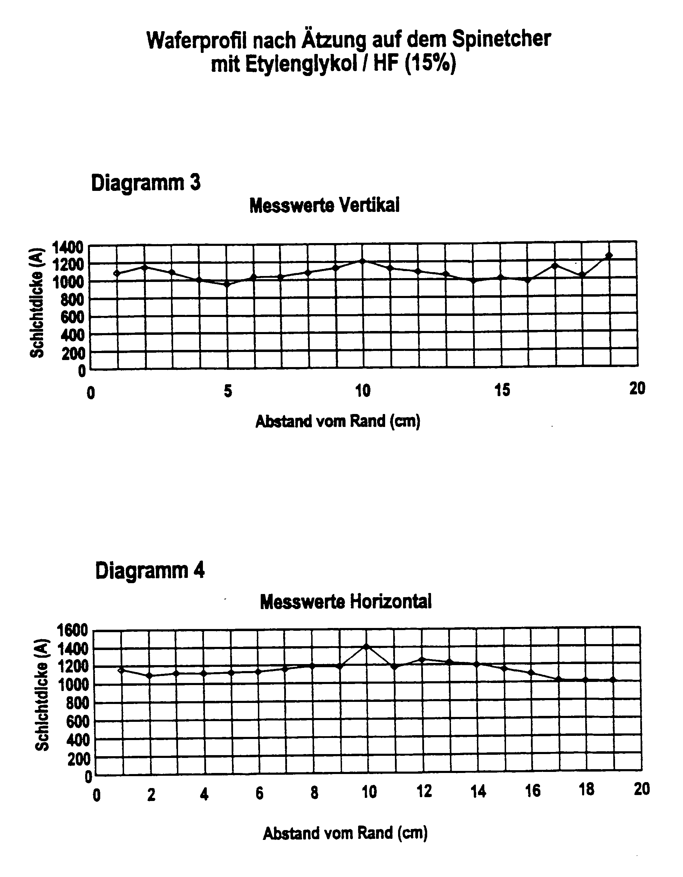

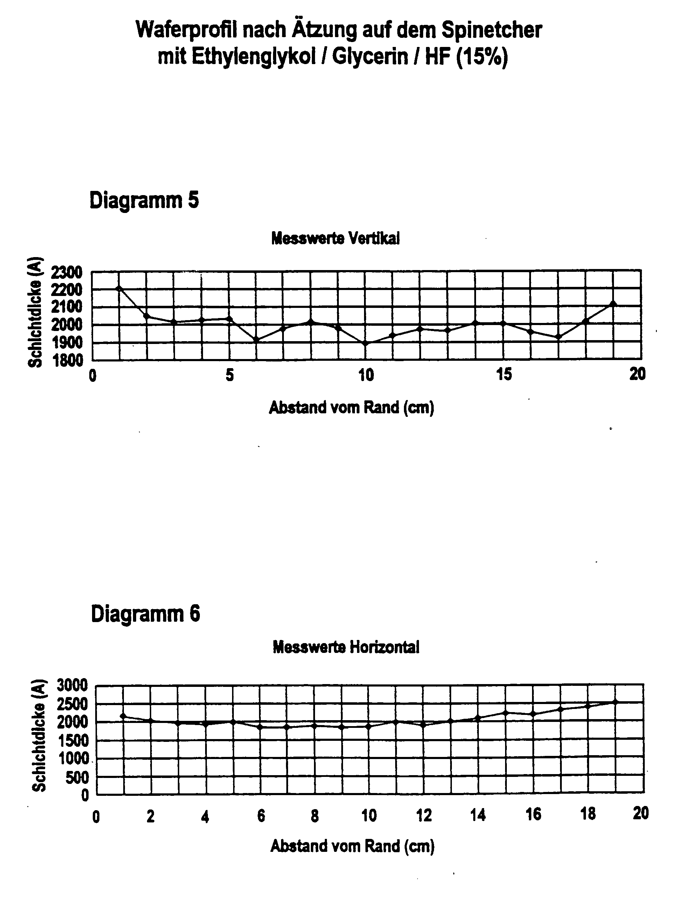

Versuche mit diesen Ätzlösungen wurden auf einem sogenannten Spinetcher, wie er von der Fa. SEZ hergestellt und vertrieben wird durchgeführt. Die Lösungen können aber auch beim Einsatz vergleichbarer Apparaturen verwendet werden. Die Funktionsweise eines solchen Spinetchers ist schematisch in Fig. 1 erläutert.

In den Diagrammen 1 - 6 ist das Waferprofil von BSG-Wafem nach dem Ätzvorgang mit zwei Mischungen, die Gegenstand der Erfindungsmeldung sind, sowie mit Spinetch F, einer Vergleichslösung, dargestellt. Deutlich geht hieraus hervor, daß die Schichtdicke nach dem Ätzen mit der Spinetch F wesentlich ungleichmäßiger ist als nach dem Ätzen mit den Mischungen gemäß der vorliegenden Erfindung. Alle Ätzversuche wurden unter Verwendung der gleichen Parameter durchgeführt.

Insbesondere wurde durch die durchgeführten Ätzversuche gefunden, daß ein zu hoher Wassergehalt sich negativ auf die Selektivität des Ätzens auswirkt. Gute Ergebnisse werden demgemäß erzielt bei einem Wassergehalt von 2 bis 20 Gew.-%. Da der Wassergehalt im wesentlichen durch die Zugabe von Flußsäure bestimmt wird, werden zur Herstellung der Ätzlösungen möglichst hochprozentige Flußsäurequalitäten eingesetzt. Anstelle von einer 50-%igen wird daher 70-%ige Flußsäure verwendet.

Zur Verdeutlichung des Einflusses der in der Ätzlösung enthaltenen Wassermenge wird in Tabelle 2 gezeigt, wie sich in der Ethylenglykol/HF-Mischung bei konstanter HF-Konzentration, aber unterschiedlichem Wassergehalt die Ätzraten und damit auch die Selektivitäten ändern.

**Tabelle 2**

| Mischung | Ätzrate BSG-Glas | therm. Oxid |
|---|---|---|
| 70 % Ethylenglykol + 15 % HF + *15* % H₂O | 3310 nm/min | 48 nm/min |
| 78,6 % Ethylenglykol + *15* % HF + 6,4 % H₂O | 2507 nm/min | 14 nm/min |

## Patentansprüche

1. Verwendung von Ätzlösungen, bestehend aus 5-20 Gew.% HF, einem organischen Lösungsmittel einzeln oder im Gemisch ausgewählt aus der Gruppe Ethylenglykol, Propylenglycol, Ethanol und Glycerin, und 1 bis 20 Gew.% Wasser, zur selektiven Ätzung von dotierten relativ zu undotierten Silikatschichten.

2. Verwendung gemäß Anspruch 1, wobei die Ätzlösung als organisches Lösungsmittel Ethylenglykol und Glycerin in einem Mischungsverhältnis von 1:10 bis 10:1 enthält.

3. Verwendung gemäß Anspruch 1, wobei die Ätzlösung als organisches Lösungsmittel Ethylenglykol und Glycerin in einem Mischungsverhältnis von 1:5 bis 5:1 enthält.

4. Verwendung gemäß der Ansprüche 1 bis 3, wobei die Ätzlösung eine Mischung aus hochreinen Einzelkomponenten enthält.

## Claims

1. The use of etching solutions consisting of 5-20% by weight of HF, a single organic solvent or an organic solvent mixture selected from the group consisting of ethylene glycol, propylene glycol, ethanol and glycerol, and 1 to 20% by weight of water, for selectively etching doped silicate layers relative to undoped silicate layers.

2. The use according to claim 1, wherein the etching solution comprises ethylene glycol and glycerol, as organic solvent, in a mixing ratio of 1:10 to 10:1.

3. The use according to claim 1, wherein the etching solution comprises ethylene glycol and glycerol, as organic solvent, in a mixing ratio of 1:5 to 5:1.

4. The use according to claims 1 to 3, wherein the etching solution comprises a mixture of high-purity individual components.

## Revendications

1. Utilisation de solutions d'attaque chimique, constituées de 5-20 % en poids de HF, d'un solvant organique seul ou en mélange, choisi dans le groupe constitué par l'éthylèneglycol, le propylèneglycol, l'éthanol et le glycérol, et 1 à 20 % en poids d'eau, pour l'attaque chimique sélective de couches de silicates dopées par rapport à celles non dopées.

2. Utilisation selon la revendication 1, dans laquelle la solution d'attaque chimique contient comme solvant organique de l'éthylèneglycol et du glycérol en un rapport de mélange de 1:10 à 10:1.

3. Utilisation selon la revendication 1, dans laquelle la solution d'attaque chimique contient comme solvant organique de l'éthylèneglycol et du glycérol en un rapport de mélange de 1:5 à 5:1.

4. Utilisation selon les revendications 1 à 3, dans laquelle la solution d'attaque chimique contient un mélange de composants individuels très purs.
